Europäisches Patentamt

European Patent Office

Office européen des brevets

(19)

(11) Publication number: **0 249 780 B1**

(12) **EUROPEAN PATENT SPECIFICATION**

(45) Date of publication of patent specification: **14.08.91**    (51) Int. Cl.⁵: **H01L 21/60, H01L 21/28**

(21) Application number: **87107759.0**

(22) Date of filing: **27.05.87**

(54) Semiconductor device with a wiring layer having a good step coverage at contact holes.

(30) Priority: **30.05.86 JP 124816/86**
**30.05.86 JP 124812/86**
**30.05.86 JP 124814/86**
**30.05.86 JP 124815/86**

(43) Date of publication of application:
**23.12.87 Bulletin 87/52**

(45) Publication of the grant of the patent:
**14.08.91 Bulletin 91/33**

(84) Designated Contracting States:
**DE FR GB**

(56) References cited:
**EP-A- 0 100 897**
**EP-A- 0 170 544**

(73) Proprietor: **FUJITSU LIMITED**
**1015, Kamikodanaka Nakahara-ku**
**Kawasaki-shi Kanagawa 211(JP)**

(72) Inventor: **Kawano, Michiari**
**31-2, Kuriya 3-chome, Tama-ku**
**Kawasaki-shi Kanagawa 214(JP)**
Inventor: **Higashimoto, Masayuki**
**532-4, Miyauchi, Nakahara-ku**
**Kawasaki-shi Kanagawa 211(JP)**
Inventor: **Kashiwagi, Shigeo**
**55-8-B-105, Ibukino, Midori-ku**
**Yokohama-shi Kanagawa 227(JP)**
Inventor: **Nakano, Jun**
**16-23, Kakinokidai, Midori-ku**
**Yokohama-shi Kanagawa 227(JP)**
Inventor: **Shimizu, Osamu**
**466-18, Edamachi, Midori-ku**
**Yokohama-shi Kanagawa 227(JP)**

(74) Representative: **Schmidt-Evers, Jürgen,**
**Dipl.-Ing. et al**
**Patentanwälte Dipl.-Ing. H. Mitscherlich**
**Dipl.-Ing. K. Gunschmann Dipl.-Ing.**
**Dr.rer.nat. W. Körber Dipl.-Ing. J. Schmidt-**
**Evers Dipl.-Ing. W. Melzer Steinsdorfstrasse**
**10**
**W-8000 München 22(DE)**

## Description

BACKGROUND OF THE INVENTION

The present invention relates to a method of fabricating semiconductor devices of improved reliability of its interconnection wirings formed on the surface of the devices. Especially it relates to the fabrication of a configuration of a wiring layer with a good step coverage for contact holes formed in an insulation layer through which the wiring layer contacts to the device electrodes.

In recent semiconductor devices, especially in integrated circuits (ICs) the dimension of the devices fabricated on a chip became very small, while the insulation layer covering the surface of the device cannot be made so thin. So, the openings of contact holes formed in the insulation layer through which the wiring layer contacts to electrodes of the devices became very small. This increases difficulties to contact the wiring layer formed on the surface of the insulation layer to the electrodes positioned on the bottom of the contact holes. The wiring layer must cover the side walls of the contact holes of the insulator. This is difficult to realize when the opening of the contact hole becomes comparative to the depth of the contact hole.

To cover a side wall of a stepped portion by wiring material is called in the art as step covering or step coverage. Usually aluminum is sputtered to form the wiring layer over the insulated surface of the devices. The step coverage of sputtered aluminum is poor, so the wiring pattern often breaks and causes a disconnection at the stepped portion on the surface of the device on which the wiring layer is formed causing malfunction of the device. In order to overcome such problem, the sputtering is done from various directions so that the side wall of the stepped portion is covered by the wiring material.

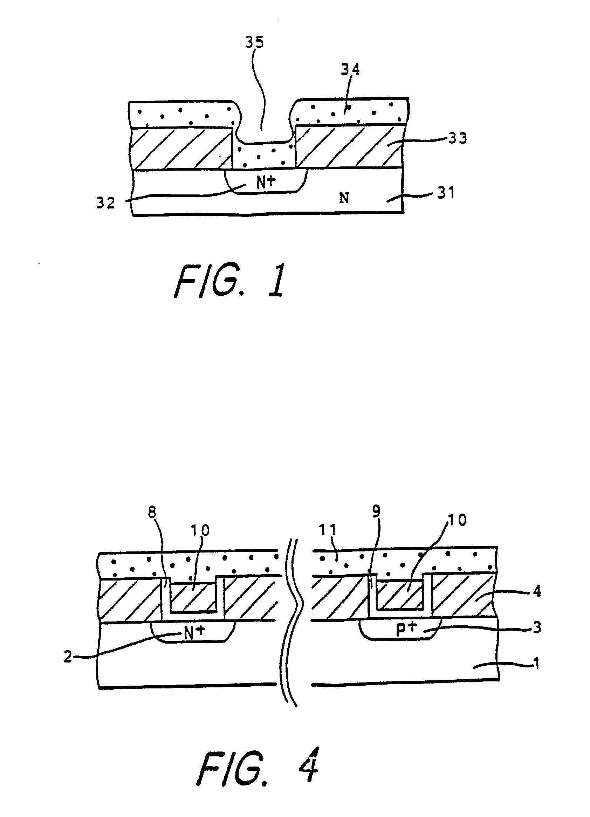

But as mentioned before, when the size of the device decreases, and the opening of the contact hole becomes comparative to the depth of the hole, the side sputtering becomes ineffective. Such situation is shown in Fig. 1, which schematically illustrates a cross section of a device at a portion close to a contact hole. In the figure, a reference numeral 31 designates an n-type silicon substrate for instance, and 32 designates an n⁺-type contact region to be contacted by the wiring layer. The region 32 may be a contact region for the device (not shown completely). A surface coating insulation layer 33 such as a silicon dioxide ($SiO_2$) layer for example is provided. A contact hole 35 is formed in the insulation layer 33 through which the wiring layer 34 contacts with the contact region 32. The wiring layer 34 is composed of aluminum sputtered on the insulation layer 33. The sputtering is done vertically and also from slanted directions in the figure. But as can be seen in the figure, the thickness of the aluminum layer on the side walls of the contact hall becomes thin at side walls of the contact hole 35. Namely, the step coverage of sputtered aluminum is poor, and it often causes disconnection of the wiring layer.

There is another problem in the aluminum wiring layer. Aluminum is liable to form an eutectic alloy with silicon, and it forms spikes which penetrate through the contact region 32 and causes a short circuit between the wiring layer 34 and the substrate 31. Several manipulations have been proposed to overcome such problems.

One proposal is to provide a thin layer (approximately 500 Å) of polycrystalline silicon (not shown) between the aluminum layer 34 and the n⁺ contact region 32. By such method, the resistivity of the silicon layer can not be reduced so much, so, recently an alloy of aluminum and silicon, tungsten or titanium is sputtered. Such method is disclosed in, for example, the EP-A-01 70 544 which discloses a semiconductor device comprising: an insulation layer covering the top surface of a substrate, a wiring layer formed on the insulation layer, a plurality of contact regions connected to the wiring layer, a plurality of contact holes formed in the insulation layer over each contact region, a conducting barrier layer deposited by vacuum evaporation in the contact holes and on the insulating layer, and burying means for filling the remaining portion of each of the contact holes, comprising a filling material which is not a good conductor and which can be even isolating. Polysilicon formed by a CVD process may be an example. There this material is essential to achieve an isotrope surface for further depositing and serves as a barrier layer material for preventing outdiffusion from the region to be in contact with.

From the EP-A-01 00 897 it is known to use a layer of highly doped polycrystalline silicon as a source for doping regions of monocrystalline silicon which polycrystalline layer can also be used for electrically contacting these regions.

In such methods as disclosed in the EP-A-170544 the problem of step coverage of the sputtered material still remains.

Another proposal is to bury the contact holes with conductive material such as polysilicon (polycrystalline silicon). In this case, the polysilicon must be doped with p or n type materials in accordance with the conductivity type of the contact regions beneath the polysilicon in order to make a good ohmic contact. If the contact regions in the chip have all same conductivity type, the doping can be done in the process to grow the polysilicon layer (chemical vapor deposition for example). But usually, the chip contains both p and n type contact regions, so the doping must be done selectively in accordance with the conductivity type of the contact regions beneath the polysilicon. Such selective doping must be done by diffusion from the surface of the grown polysilicon layer. But the conductivity of the diffused layer becomes low as the distance from the surface becomes large. Therefore, the resistivity of the buried material in the contact holes becomes high, and so the resistance of the wiring layer increases. Accordingly, though such method had been proposed, its adoption in practical use was very rare.

The conductivity of the wiring layer has increasing importance for devices which are operated in high speed and for large scale integrated circuits in order to decrease the heat dissipation.

## SUMMARY OF THE INVENTION

Object of the present invention, therefore, is to provide a semiconductor device which wiring layer has a good step coverage for contact holes.

Another object of the present invention is to increase the reliability of semiconductor devices by preventing disconnections and spikes of the wiring layer.

Still another object of the present invention is to provide a structure of a semiconductor device desirable for attaining the foregoing objects.

Further object of the present invention is to provide a fabrication process for realizing the foregoing objects.

These objects are achieved by a method according to claim 1.

According to the present invention, in the contact holes of the insulation layer through which the wiring layer contacts to the device electrodes formed a polysilicon film is formed. The polysilicon film is formed by chemical vapor deposition (CVD), which deposits the material almost uniformly on the surface to be deposited regardless to the direction. Therefore, the side walls of the contact holes are covered with a polysilicon film having almost the same thickness as on the top surface of the insulation layer. The polysilicon film at the portions of the contact holes are selectively doped by ion implantation to have the same conductivity as that of respective contact regions. This doped polysilicon film provides a first conductive layer having a good step coverage for the contact holes.

The portions of the first conductive layer positioned in each contact holes are buried with a thick layer of silicon dioxide ($SiO_2$), so the surface of the device becomes flat. Over such flat surface, the wiring layer is formed. So, the problem of step coverage and spikes of eutectic material have been avoided, and a good ohmic contact is secured.

As a variation of the first embodiment, the thick silicon dioxide layer is replaced by a thin silicon dioxide layer, and the remaining part of the contact hole is buried with some other materials, such as polysilicon, or amorphous silicon etc. In any case, the polysilicon film should be covered with a silicon dioxide film. The reason will be discussed in the following detailed description of the invention.

According to the second embodiment of the invention, a barrier layer made from silicide of metals having high melting point ($WSi_2$ for example) is added on the surface of the polysilicon film described in the first embodiment. This barrier layer prevents the disconnection or decrease of conductivity of wiring layer caused by migration of metal (especially aluminum) on the silicon. The barrier layer is also formed by CVD, so its step coverage is good, and it provides second conductive layer to connect between the contact region and the wiring layer. So, the contact resistance is further decreased.

According to the third embodiment, the barrier layer is formed by a metal having a high melting point, tungsten, molybdenum, or platinum etc. As a modification of the third embodiment, the metal layer is heat treated to form a silicide barrier layer. These and other modifications and advantages of the invention will be described in detail in following description of preferred embodiments.

## BRIEF DESCRIPTION OF DRAWINGS

Fig. 1 shows schematically a cross section of a device at a portion close to a contact hole illustrating a poor step coverage of the wiring layer formed by prior art.

Fig. 2 shows a cross section of a portion of the device close to contact holes illustrating production steps for fabricating a wiring layer of the first embodiment of the present invention.

Fig. 3 illustrates a first modification of the production steps of the first embodiment, wherein a silicon dioxide film 21 is added to cover the surface of the polysilicon films 8 and 9 in order to make the etching back step easy, and the material burying the contact holes are changed.

Fig. 4 shows a second modification of the first embodiment illustrating a cross section of the contact holes corresponding to that of Fig. 2(f), wherein the silicon dioxide layer 10 has been intentionally overetched to secure a better contact of the wiring layer 11 to the polysilicon films 8 and 9.

Fig. 5 shows a cross section of a portion of the device close to the contact holes illustrating a second embodiment of the present invention, wherein a barrier layer 12 is added to prevent the migration of wiring metal 11.

Fig. 6 shows a variation of the second embodiment, wherein the material burying the contact holes is replaced by thin layer of silicon dioxide 21 and polysilicon 22 or amorphous silicon.

Fig. 7 illustrates the production steps for a third embodiment, wherein the barrier layer is formed by a layer of metal having a high melting point.

Fig. 8 illustrates the production steps for a variation of the third embodiment, disclosing a method to convert the metal barrier layer to a silicide barrier layer.

## DESCRIPTION OF PREFERRED EMBODIMENTS

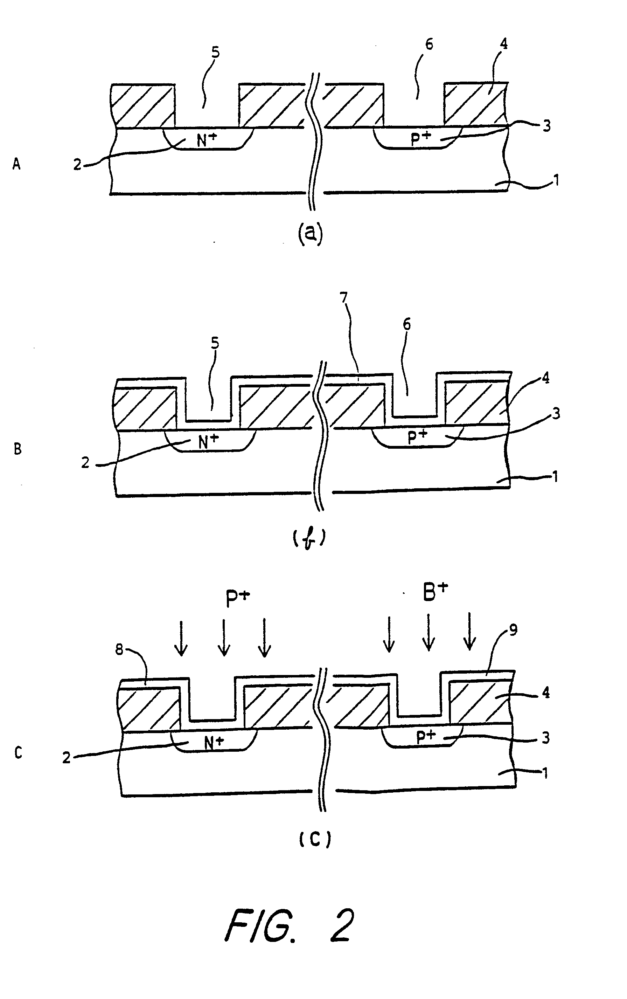

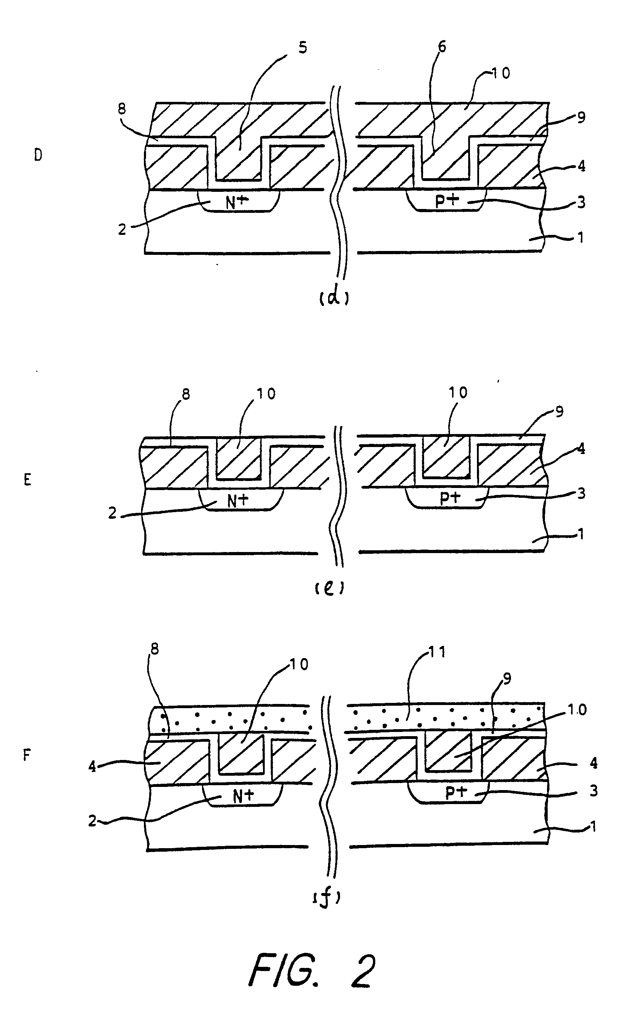

Now, the advantage of the present invention will be described referring to the preferred embodiments. Fig. 2 illustrates fundamental steps of the fabrication process to realize a first embodiment of the present invention. In the disclosure hereinafter a substrate of n type silicon is used as an example. But it will be apparent that the substrate may be replaced by one having another type of conductivity. In the description hereinafter the steps of the process will be referred to by the respective figure.

As shown in Fig. 2(a), the surface of an n type silicon substrate 1 is covered with an insulation layer 4 which may be a silicon dioxide layer of 1 $\mu$m thick for example. And over the $n^+$ and $p^+$ type contact regions 2 and 3 contact holes 5 and 6 are formed. These contact regions may be electrodes of the device (not shown) fabricated in the substrate 1. They are fabricated by ordinary semiconductor device fabrication technology of diffusion and photolithography etc.

Next, as shown in Fig. 2 (b), over the entire surface of the substrate a polysilicon layer 7 of approximately 200 nm thick is deposited by chemical vapor deposition (CVD). The thickness of the polysilicon layer 7 may be appropriate 100-300 nm for example. As mentioned before, the CVD process deposits a material uniformly over the surface regardless to its inclination. So, the deposited polysilicon layer has almost equal thickness at the side walls and at the top surface of the device. Namely, the step coverage is very good.

Subsequently, as shown in Fig. 2(c), the polysilicon layer at the portions of contact holes 5 and 6 are selectively doped with n type or p type impurities by ion implantation corresponding to the conductivity type of the contact region to which the polysilicon layer is contacted, and converted into n type or p type polysilicon layers 8 and 9. They provide good ohmic contact to the n or p type contact regions 2 or 3. The ion implantation for p type impurity is done using phosphorus ions ($P^+$) with a dosage of more than $10^{15}$/cm$^2$ with an acceleration energy of 50 keV for example, and the ion implantation for n type impurity is done using boron ions ($B^+$) with almost the same doping conditions. The doped area may extend over the top surface of the substrate around the contact hole. Therefore, the area of the selective ion implantation is not so critical. The wider area provides a better contact to the wiring layer which is fabricated over the polysilicon layer by the following steps. The above described fabrication processes are all conventional ones, and they must be varied in accordance with the device to be fabricated. But they are not relevant to the invention, so, further description is omitted for the sake of simplicity.

Next, as shown in Fig. 2(d), on the surface of the substrate a thick SiO$_2$ layer 10 is deposited by CVD. The SiO$_2$ layer has enough thickness to bury the contact holes 5 and 6.

Then as shown in Fig. 2(e), the SiO$_2$ layer 10 is etched back to expose the surface of the n and p type polysilicon layers 8 and 9. Conventional dry etching is applicable for this step. The etching rates of SiO$_2$ and polysilicon are different from each other, so it is possible to stop the etching when the polysilicon layers 8 or 9 are disposed from the SiO$_2$ layer 10. By this process the contact holes are buried perfectly by the SiO$_2$ layer 10, and the surface of the device becomes flat as shown in the figure.

Succeedingly, as shown in Fig. 2(f), a wiring layer 11 is formed over the flat surface of the device. The wiring layer may be fabricated with any kind of material, but aluminum is most popular in the art. The aluminum is sputtered by a conventional method, and the aluminum layer 11 is patterned by conventional photolithography to a predetermined pattern to interconnect the electrodes. The surface of the device is then passivated by a conventional manner and the device is finished.

As can be seen in Fig. 2(f), the n and p type contact regions 2 and 3 are connected to the wiring layer 11 by the n and p type polysilicon films 8 or 9 respectively. The step coverage of the polysilicon films 8 and 9 are very good, so disconnections at the side walls of the contact holes do not occur. Moreover, the surfaces of the contact regions 2 and 3 are not directly contacted by aluminum, a short circuit caused by growth of spikes formed by an eutectic of aluminum and silicon has been avoided.

The above disclosed process for fabricating the first embodiment of the present invention is a fundamental process. But it is possible to make several modifications each having further improvements or advantages over the first embodiment.

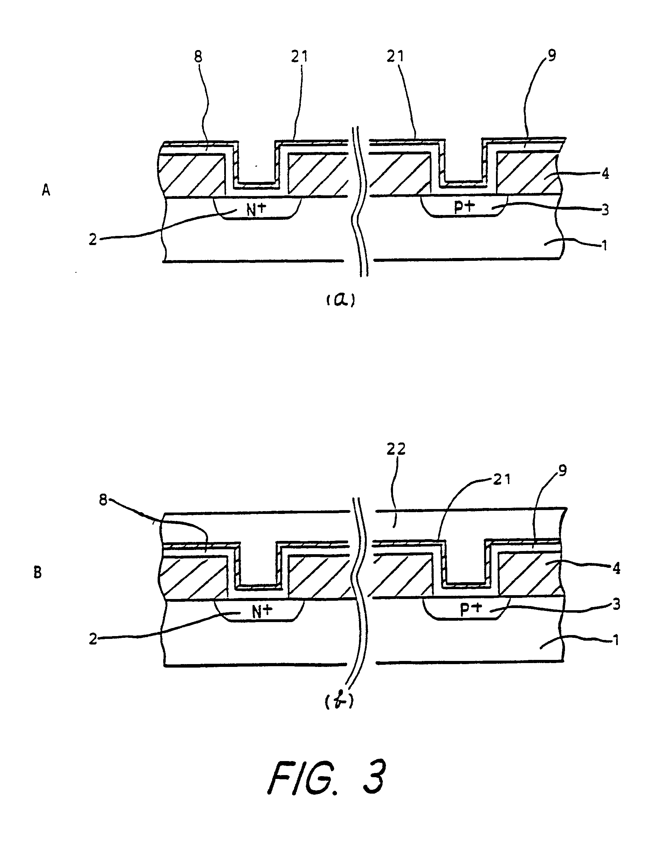

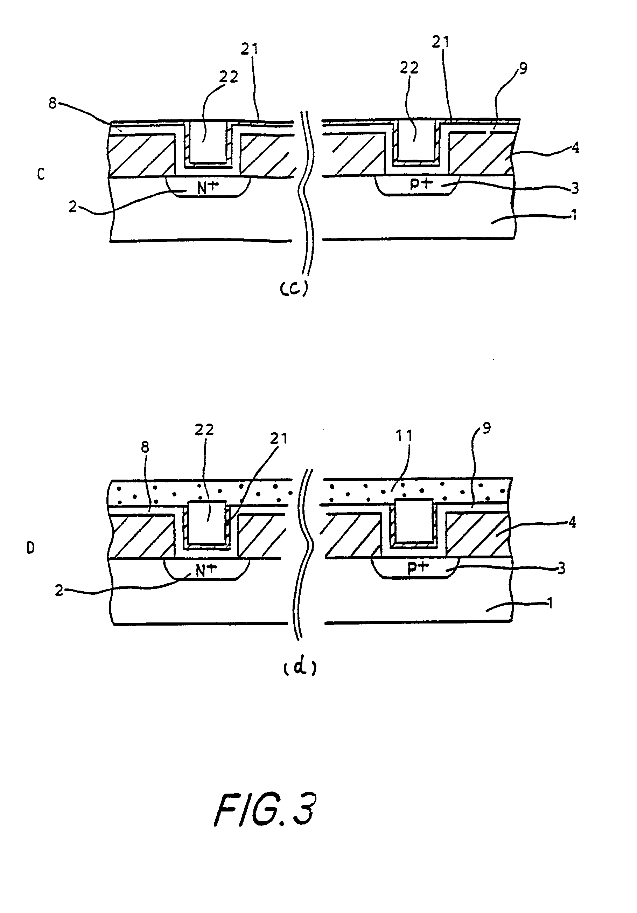

Fig. 3 illustrates a first modification of the production steps of the first embodiment, wherein a silicon dioxide film 21 is added to cover the surface of the polysilicon film 9. This modification is proposed to make ease to determine the end point of the etching back process of Fig. 2(e). The process of Figs. 2(a) through 2(c) are same to those of the first embodiment. Following the process 2(c) of Fig. 2, as shown in Fig. 3(a), a thin $SiO_2$ layer 21 of approximately 50 nm is formed over the entire surface of the device. Thermal oxidation is preferable for this step. Then the thick polysilicon layer 22 is formed over the entire surface of the device to bury the contact holes as shown in Fig. 3(b). Then the thick polysilicon layer 22 is etched back by conventional dry etching. Since the etching rate of the polysilicon is much larger than that of silicon dioxide, so, it is easy to stop the etching back process correctly at the level of the surface of the thin $SiO_2$ film 21 as shown in Fig. 3(c). After etching off the exposed thin $SiO_2$ film 21, the process of Fig. 2(d) is followed. So, the final cross section of the device becomes as shown in Fig. 3-(d). In Fig. 3(d), the surface of the $SiO_2$ layer 22 is shown to be protruded upward from the level of the polysilicon layer 8 or 9, to emphasis the thickness of the etched $SiO_2$ layer 21. But as has been described above, the thickness of the $SiO_2$ 21 is only 50 nm, moreover, the polysilicon layer 22 is also etched to some extent by the etchant for the $SiO_2$. Therefore, the top surface of the polysilicon layer 22 is substantially equal to the top surface of the polysilicon layer 8 or 9.

Compared to the device fabricated by the first modification to that of the first embodiment, the material burying the contact holes 22 are replaced by polysilicon, but the effect is same. It should be pointed out that by adding the thin $SiO_2$ film 21, it becomes possible to replace the material to bury the contact holes to any other materials, such as amorphous silicon for example. And the control of the etching back process becomes easier. It will be understood for the one in the art that the thin $SiO_2$ layer 21 in the process of Fig. 3(a) may be replaced by some other insulator layer, such as silicon nitride ($Si_3N_4$) for example.

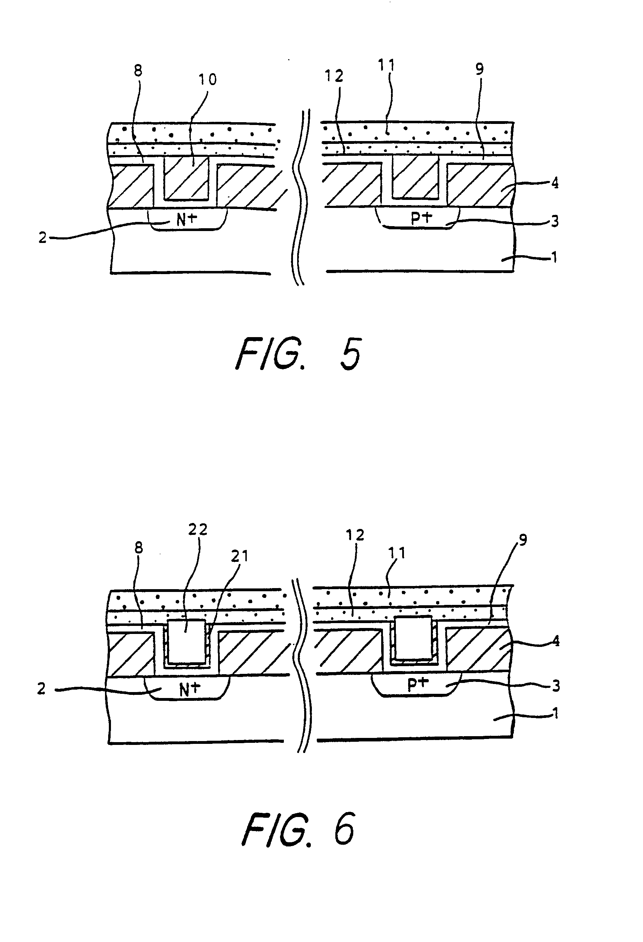

Fig. 4 shows a second modification of the first embodiment illustrating a cross section of the contact holes corresponding to that of Fig. 2(f), wherein the level of the silicon dioxide layer 10 has been slightly withdrawn from the level of the $SiO_2$ layer 4. Such modification is effective when the polysilicon layers 8 and 9 extending over the top surface of the device are removed in order to reduce the contact area to increase the packing density of the devices in the IC. Such modification is possible by slightly overetching the $SiO_2$ layer 10 at the process of Fig. 2(e). By such small overetching, there occurs no problem of step covering. And it will be clear that the configuration of Fig. 4 provides a more wide contact area between the polysilicon layers 8 and 9 to the wiring layer 11. In Fig. 4, the thickness of the polysilicon layers 8 and 9 are approximately 200 nm corresponding to Fig. 2(d). Therefore, the contact area between the polysilicon layers 8 or 9 and the wiring layer 11 is very small. But as can be seen in Fig. 4, when the level of the $SiO_2$ layer 10 is slightly withdrawn, the side walls of the polysilicon layers 8 and 9 can be also used as the contact are by the wiring layer 11, so, the contact area is increased by such overetching. And the contact resistance is reduced.

Coming back to Fig. 2(f) that shows a cross section of the first embodiment, the contact area between the wiring layer 11 and the polysilicon films 8 or 9 are very wide, therefore, the problem of the contact resistance does not occur. But it became apparent, that if aluminum is contacted for a long time on the polysilicon, and if the device is heated or voltage is applied between the wiring layer and the substrate, the aluminum migrates over the surface of the polysilicon, and in a long time period, the conductivity of the wiring layer decreases.

The second embodiment of the present invention intends to overcome the problem of migration of metals on the polysilicon. The migration is avoided by adding a barrier layer between the polysilicon and the metal layer. Fig. 5 illustrates a cross sectional view close to the contact holes of the second embodiment. The figure corresponds to Fig. 2(f). Compared to that, to the second embodiment of Fig. 5 is added a barrier layer denoted by the reference numeral 12. The barrier layer 12 is composed of silicide of a high melting point metal such as tungsten, molybdenum or platinum. The barrier layer composes a second conductive layer between the wiring layer 11 and the first conductive layer composed of the polysilicon layers 8 and 9.

Such material of barrier layer is deposited by CVD. It will be understood for the one skilled in the art, that the deposition of the barrier layer can be done between the steps of Fig. 2(e) and Fig. 2(f) described with respect to Fig. 2. In an example, a tungsten silicide ($WSi_2$) film of approximately 100 nm has been deposited by CVD. By the barrier layer 12, the migration of the metal has been avoided. Several modifications are possible for the second embodiment described with respect to Fig. 5.

Fig. 6 shows a first modification of the second embodiment. It will be clear for the one in the art that the barrier layer 12 is added to the device shown in Fig. 3(d). Therefore, the deposition of the barrier layer 12 should be done between the steps of Fig. 3(c) and Fig. 3(d) described with respect to Fig. 3. The effect of preventing the migration of aluminum is further added to the device of Fig. 3-(d).

In the above disclosure, the barrier layer 12 is composed of a silicide of high melting point metals.

But it is possible to avoid the migration of metals by other method. In a third embodiment of the present invention, the barrier layer is formed by a high melting point metal layer.

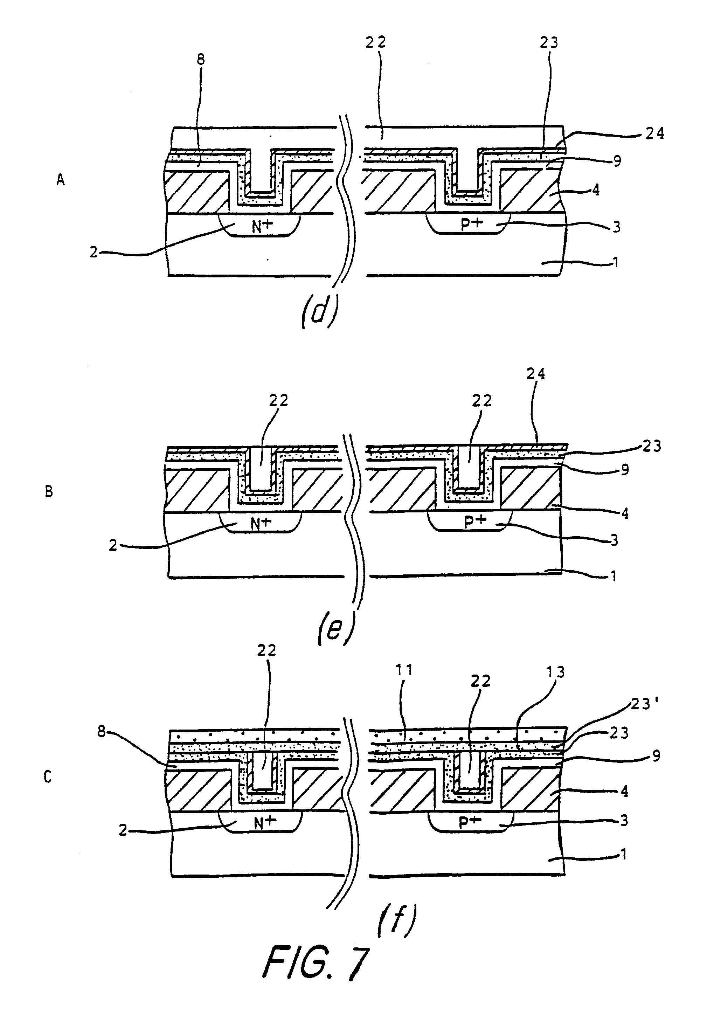

Fig. 7 shows the steps to form the barrier layer composed from a metal layer of a high melting point metal such as tungsten, molybdenum or platinum. Such material will be denoted as a barrier metal hereinafter. The process begins following the step of Fig. 2(c) described with respect to Fig. 2.

As shown in Fig. 7(d), the barrier metal layer 23 of approximately 50-100 nm thick, a second thin $SiO_2$ layer 24 of approximately 50 nm and a thin polysilicon layer 22 are successively deposited by CVD on the entire surface of the substrate. The step coverage of theses layers are very good, because they are deposited by CVD, and the thin polysilicon layer 22 buries the contact holes. Then, the polysilicon layer 22 is etched back as shown in Fig. 7(e). Dry etching is applicable for such purpose. Subsequently, as shown in Fig. 7(f), the etched surface of the substrate is covered with the barrier metal layer 23', over which the wiring layer 11 is formed. The latter step is similar to the step of Fig. 2(f) described with respect to Fig. 2.

Comparing the device of Fig. 7(f) to that of Fig. 6, the barrier layer 23 and 23' are added over the polysilicon layers 8 and 9. These layers not merely provide the effect of preventing the migration of a metal over the polysilicon, but they increase the conductivity of the layer to connect between the contact regions 2 or 3 and the wiring layer 11. Since the conductivity of the doped polysilicon is not so high, and its thickness is very thin, the barrier layer becomes a second conducting layer connecting between the contact region and the wiring layer. So, the characteristics of the device is further improved.

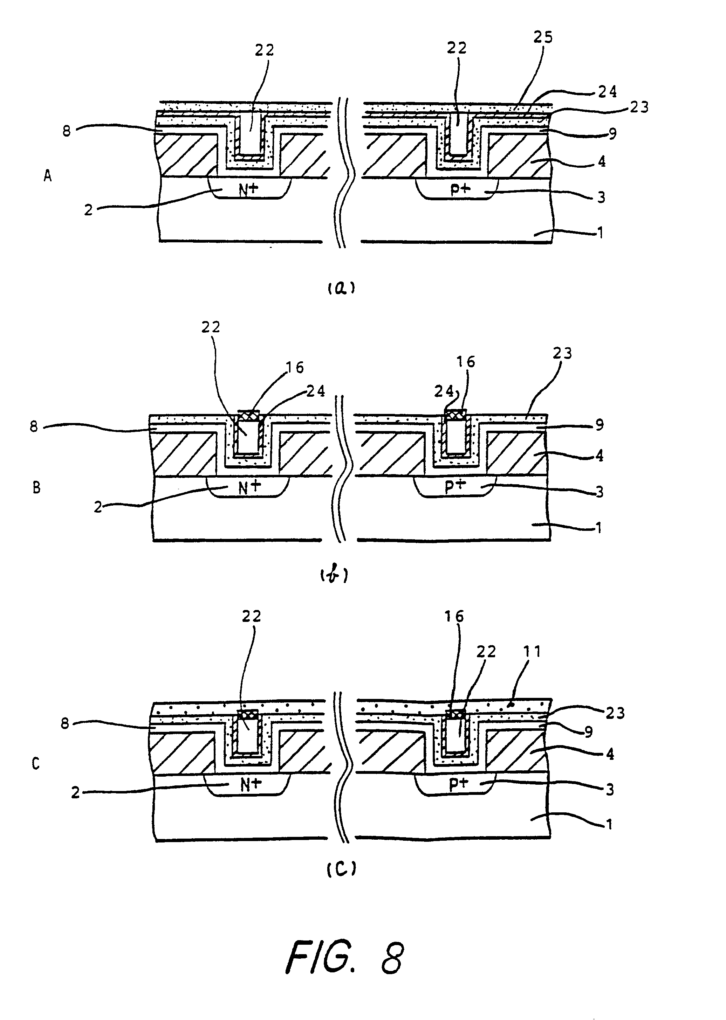

As a modification of the third embodiment, the metal barrier layer is converted to silicide by heat treatment. The fabrication process follows the step of Fig. 7(e). As shown in Fig. 8(a), second barrier metal layer 25 of approximately 100 nm is formed over the surface of the substrate. CVD or sputtering are applicable for this step.

Next, the chip is annealed at a temperature of 600 - 800 °C to convert the barrier metal to silicide. So, the second barrier metal layer 25 and the polysilicon layer 22 burying the contact hole react to each other and form a silicide layer 16. As can be seen in Fig. 8(a), the reaction occurs only at a portion where the barrier metal is contacted to the silicon (polysilicon). So, the silicide layer 16 is formed only at the portion of the contact holes as shown in Fig. 8(b). Then the remaining second barrier metal layer 25 is selectively etched off. The etching is done by dry etching. When the etching is completed, the appearance becomes as shown in Fig. 8(b).

Then, the following steps to form the wiring layer 11 are similar to those of Fig. 2(f). The cross section of the contact holes at the final state becomes as shown in Fig. 8(c). As can be seen in Fig. 8(c), the wiring layer which is usually aluminum, does not directly contact to silicon (polysilicon), so the migration is avoided. The contact between the contact regions 2 or 3 and the wiring layer 10 is secured by double layer of a n or p type polysilicon layer 8 or 9 and the barrier metal layer 9. So the conductivity is further improved to that of Fig. 7(f).

Modification of the third embodiment is also possible, it starts from the process step of Fig. 3(c) described with respect to Fig. 3(c). The thin $SiO_2$ layer 21 is etched off. Then the entire surface is covered with a barrier metal layer (not shown), and the chip is annealed to convert the barrier metal layer to silicide. In this case the entire top surface of the chip is converted to the silicide and becomes the barrier layer. It will be understood for the one skilled in the art that, when the wiring layer 11 is formed on this barrier layer, the device becomes similar to that shown in Fig. 6.

By the present invention, as have been described above, the contact holes formed in an insulation layer are coated inside with a conductive polysilicon layer having the same conductivity type to that of the contact regions of the device fabricated beneath the insulation layer. The step coverage of the polysilicon layer is very good because it is formed by chemical vapor deposition. Remaining portions of the contact holes are buried with a burying means which includes silicon dioxide. By doing so, a disconnection of the wiring layer is avoided and the reliability of the wiring is increased. The short circuit caused by growth of spikes formed by an eutectic of silicon and metal is also avoided.

The material composing the burying means which buries the remaining portions of the contact holes may be $SiO_2$. It may be replaced by other materials such as polysilicon or amorphous silicon, but in order to do so, at least a layer of an insulation film such as $SiO_2$ or $Si_3N_4$ is necessary to cover the surface of the conductive polysilicon layer.

The present invention further may add a barrier layer between the wiring layer and silicon (it may be polysilicon or amorphous silicon) to prevent the migration of metal (especially aluminum) over the silicon surface. This barrier layer becomes a second conductive layer to connect between the wiring layer and the contact region of the device. This further increases the conduction between the contact area and the wiring layer.

The barrier layer is made from silicide of a high melting point metal such as tungsten, molybdenum, titanium or platinum. But the barrier layer may be composed of a film of such a high melting point metal. By using such material, the conductivity of the wiring layer is further increased. Such increase of conductivity is important for a device operated with high speed or decreasing heat generation of the chip.

In the above disclosure, the conductivity type of the substrate has been supposed to be n type, but it will be apparent that the invention may be applied to a substrate having any type of conductivity, and dimensions of the device described with respect to the embodiments are to be considered in all respects as illustrative and not restrictive.

**Claims**

1. A method for fabricating a semiconductor device having:

   contact holes (5, 6) formed in an insulation layer (4) covering the device,

   a wiring layer (11) fabricated on said insulation layer (4), said wiring layer (11) connecting contact regions (2, 3) of said device through said contact holes (5, 6) and

   burying means (10) including at least portions covering the inner surface of said contact holes (5, 6),

   said method comprises the process steps in succession:

   (a) covering the surface of the device with said insulation layer (4) and forming said contact holes (5, 6) at predetermined positions to expose said respective contact regions (2, 3);

   (b) depositing a first polysilicon layer (7) over the entire surface of said device by a chemical vapor deposition (CVD);

   (c) selectively doping said polysilicon layer (7) at portions (8, 9) close to said contact holes (5, 6) with n and p type dopant respectively in accordance with the conductivity type of the contact regions (2, 3) to which said polysilicon layer (7) is contacted;

   (d) depositing burying means including at least a portion composed of an insulator composed of silicon dioxide or silicon nitride (10) over the entire surface of said device until said contact holes (5, 6) are buried;

   (e) etching back said burying means (10) until the surface of said conductive polysilicon layer (7) covering the top surface of said device is exposed; and

   (f) forming said wiring layer (11) on the surface of said device and patterning it to a predetermined pattern.

2. Method according to claim 1 wherein said burying means are composed of a thick silicon dioxide layer.

3. A method according to claim 1, further comprising the following step between the steps (e) and (f):

   depositing a layer (12) composed of silicide of a high melting point metal.

4. A method according to claim 1, wherein the steps (d) and (e) comprise:

   (d₁) depositing a thin silicon dioxide ($SiO_2$) or silicon nitride ($Si_3N_4$) film (21) over the entire surface of said device;

   (d₂) depositing a thick polysilicon or amorphous silicon layer (22) over the entire surface of said device until said contact holes (5, 6) are buried; and

   (e₁) etching back said thick polysilicon or amorphous silicon layer (22) until the surface of said thin $SiO_2$ or $Si_3N_4$ film (21) is exposed;

   and continuing with the step (f).

5. A method according to claim 4 further comprising the following step between the steps (e₁) and (f):

   etching off said thin $SiO_2$ or $Si_3N_4$ film (21) exposed on the top surface of said device, and depositing a layer (12) composed from silicide of a high melting point metal.

6. A method according to claim 1, wherein the steps (d) and (e) comprise:

   (d₁₁) successively forming, by CVD, a barrier layer (23) of a high melting point metal and a thin second $SiO_2$ or $Si_3N_4$ film (24) over the entire surface of said device, and succeedingly depositing a thick polysilicon or amorphous silicon layer (22) over the entire surface of the device until said contact holes (5, 6) are buried; and

   (e₁₁) etching back said polysilicon or amorphous silicon layer (22) and said second thin $SiO_2$ or $Si_3N_4$ film (24) until the surface of said high melting point metal film is exposed;

   and continuing with the step (f).

7. A method according to claim 6, further comprising the following steps between the steps (e₁₁) and (f):

   forming a second high melting point metal film (25) over the entire surface of said device; and

converting said second high melting point metal film (25) to a silicide film (16) by heat treatment, and etching off the remaining high melting point metal.

**Revendications**

1. Une méthode pour fabriquer un dispositif à semi-conducteur ayant :

   des trous de contact (5, 6) formés dans une couche d'isolation (4) recouvrant le dispositif,

   une couche de câblage (11) fabriquée sur ladite couche d'isolation (4), ladite couche de câblage (11) connectant des régions de contact (2, 3) dudit dispositif à travers lesdits trous de contact (5, 6) et

   des moyens pour enterrer (10) incluant au moins des portions recouvrant la surface intérieure desdits trous de contact (5, 6),

   ladite méthode comprend les étapes successives de procédé suivantes :

   (a) recouvrement de la surface du dispositif par ladite couche d'isolation (4) et formation desdits trous de contact (5, 6) dans des positions prédéterminées pour exposer lesdites régions de contact respectives (2, 3) ;

   (b) dépôt d'une première couche de polysilicium (7) par-dessus la surface entière dudit dispositif par dépôt chimique en phase vapeur (CVD) ;

   (c) dopage sélectif de ladite couche de polysilicium (7) dans les portions (8, 9) proches desdits trous de contact (5, 6) avec un dopant du type n et p respectivement en accord avec le type de conductivité des régions de contact (2, 3) avec lesquelles ladite couche de polysilicium (7) est en contact ;

   (d) dépôt des moyens pour enterrer incluant au moins une portion composée d'un isolateur composé de dioxyde de silicium ou de nitrure de silicium (10) par-dessus la surface entière dudit dispositif jusqu'à ce que lesdits trous de contact (5, 6) soient enterrés ;

   (e) gravure en retrait desdits moyens pour enterrer (10) jusqu'à ce que la surface de ladite couche de polysilicium conductrice (7) recouvrant la surface de dessus dudit dispositif soit exposée ; et

   (f) formation de ladite couche de câblage (11) sur la surface dudit dispositif et application à ladite couche d'un motif prédéterminé.

2. Méthode selon la revendication 1, selon laquelle lesdits moyens pour enterrer sont composés d'une couche épaisse de dioxyde de silicium.

3. Une méthode selon la revendication 1, comprenant en outre l'étape suivante entre les étapes (e) et (f) :

   dépôt d'une couche (12) composée de siliciure d'un métal à point de fusion élevé.

4. Une méthode selon la revendication 1, selon laquelle les étapes (d) et (e) comprennent :

   (d$_1$) le dépôt d'un film mince (21) de dioxyde de silicium (SiO$_2$) ou de nitrure de silicium (Si$_3$N$_4$) sur la surface entière dudit dispositif ;

   (d$_2$) le dépôt d'une couche épaisse de poly-silicium ou de silicium amorphe (22) sur la surface entière dudit dispositif jusqu'à ce que lesdits trous de contact (5, 6) soient enterrés ; et

   (e$_1$) la gravure en retrait de ladite couche épaisse de poly-silicium ou de silicium amorphe (22) jusqu'à ce que la surface dudit film (21) mince de SiO$_2$ ou de Si$_3$N$_4$ soit exposée ;

   et la continuation par l'étape (f).

5. Une méthode selon la revendication 4, comprenant en outre l'étape suivante entre les étapes (e$_1$) et (f) :

   élimination par gravure dudit film mince de SiO$_2$ ou de Si$_3$N$_4$ (21) exposé sur la surface de dessus dudit dispositif, et dépôt d'une couche (12) composée de siliciure d'un métal à point de fusion élevé.

6. Une méthode selon la revendication 1, selon laquelle les étapes (d) et (e) comprennent :

   (d$_{11}$) la formation successive par le procédé CVD d'une couche de barrière (23) d'un métal à point de fusion élevé et d'un second film mince de SiO$_2$ ou de Si$_3$N$_4$ (24) sur la surface entière dudit dispositif, puis le dépôt qui succède d'une couche épaisse de poly-silicium ou de silicium amorphe (22) sur la surface entière du dispositif jusqu'à ce que lesdits trous de contact (5, 6) soient enterrés ; et

   (e$_{11}$) la gravure en retrait de ladite couche de polysilicium ou de silicium amorphe (22) et dudit second film mince de SiO$_2$ ou de Si$_3$N$_4$ (24) jusqu'à ce que la surface dudit film de métal à point de fusion élevé soit exposée ; et

   la continuation par l'étape (f).

7. Une méthode selon la revendication 6, comprenant en outre les étapes suivantes entre les étapes (e$_{11}$) et (f) :

formation d'un second film de métal à point de fusion élevé (25) sur la surface entière dudit dispositif ; et

conversion dudit second film de métal à point de fusion élevé (25) en un film de siliciure (16) par traitement thermique, et élimination par gravure du restant du métal à point de fusion élevé.

**Patentansprüche**

1. Verfahren zur Herstellung einer Halbleitervorrichtung, die aufweist:

Kontaktlöcher (5, 6), die in einer Isolierschicht (4) ausgebildet sind, welche die Vorrichtung abdeckt,

eine Leiterbahnschicht (11), die auf der Isolierschicht (4) hergestellt ist, wobei die Leiterbahnschicht (11) Kontaktbereiche (2, 3) der Vorrichtung durch die Kontaktlöcher (5, 6) verbindet und

ein Vergrabungselement (10), das zumindest Teile enthält, die die innere Oberfläche der Kontaktlöcher (5, 6) abdecken,

welches Verfahren aufeinanderfolgend Prozeßschritte enthält zum

(a) Bedecken der Oberfläche der Vorrichtung mit der Isolierschicht (4) und Ausbilden der Kontaktlöcher (5, 6) an vorbestimmten Stellen, um die betreffenden Kontaktbereiche (2, 3) freizulegen,

(b) Aufbringen einer ersten Polysiliziumschicht (7) über die gesamte Oberfläche der Vorrichtung durch chemische Aufdampfung (CVD),

(c) selektives Dotieren der Polysiliziumschicht (7) in Bereichen (8, 9) dicht an den Kontaktlöchern (5, 6) mit n- bzw. p-Dotierstoff in Übereinstimmung mit dem Leitungstyp der Kontaktbereiche (2, 3), mit denen die Polysiliziumschicht (7) kontaktiert ist,

(d) Aufbringen des Vergrabungselements, das zumindest einen Teil enthält, der aus einem Isolator besteht, welcher aus Siliziumdioxid oder Siliziumnitrid zusammengesetzt ist, über die gesamte Oberfläche der Vorrichtung, bis die Kontaktslöcher (5, 6) vergraben sind,

(e) Zurückätzen des Vergrabungselements (10), bis die Oberfläche der leitenden Polysiliziumschicht (7), die die obere Fläche der Vorrichtung bedeckt, freigelegt ist, und

(f) Bilden der Leiterbahnschicht (11) auf der Oberfläche der Vorrichtung und Ausbilden derselben in einem vorbestimmten Muster.

2. Verfahren nach Anspruch 1, bei dem das Vergrabungselement aus einer dicken Siliziumdioxidschicht gebildet ist.

3. Verfahren nach Anspruch 1, das ferner den folgenden Schritt zwischen den Schritten (e) und (f) enthält:

Aufbringen einer Schicht (12), die aus Silizid eines hochschmelzenden Metalls zusammengesetzt ist.

4. Verfahren nach Anspruch 1, bei dem die Schritte (d) und (e) umfassen:

($d_1$) Aufbringen eines dünnen Siliziumdioxid ($SiO_2$- oder Siliziumnitrid ($Si_3N_4$)-Films (21) über die gesamte Oberfläche der Vorrichtung,

($d_2$) Aufbringen einer dicken Polysilizium- oder Amorphsilizium-Schicht (22) über die gesamte Oberfläche der Vorrichtung, bis die Kontaktlöcher (5, 6) vergraben sind, sowie

($e_1$) Zurückätzen der dicken Polysilizium- oder Amorphsilizium-Schicht (22), bis die Oberfläche des dünnen $SiO_2$-oder $Si_3N_4$-Films (21) freigelegt ist, und Fortsetzen mit Schritt (f).

5. Verfahren nach Anspruch 4, das ferner den folgenden Schritt zwischen den Schritt ($e_1$) und (f) umfaßt:

Wegätzen des dünnen $SiO_2$- oder $Si_3N_4$-Films (21), der auf der oberen Oberfläche der Vorrichtung freigelegt ist, und Aufbringen einer Schicht (12), die aus Silizid eines hochschmelzenden Metalls zusammengesetzt ist.

6. Verfahren nach Anspruch 1, bei dem die Schritte (d) und (e) umfassen:

($d_{11}$) aufeinanderfolgendes Ausbilden einer Randschicht (23) eines hochschmelzenden Metalls und eines dünnen zweiten $SiO_2$- oder $Si_3N_4$-Films (24) mittels CVD über die gesamte Oberfläche der Vorrichtung und nachfolgendes Aufbringen einer dicken Polysilizium- oder AmorphsiliziumSchicht (22) über die gesamte Oberfläche der Vorrichtung, bis die Kontaktlöcher (5, 6) vergraben sind, sowie

($e_{11}$) Zurückätzen der Polysilizium- oder Amorph-silizium-Schicht(22) und des dünnen zweiten $SiO_2$- oder $Si_3N_4$-Films (24), bis die Oberfläche des hochschmelzenden Metallfilms freigelegt ist, und Fortsetzen mit Schritt (f).

7. Verfahren nach Anspruch 6, das ferner die folgenden Schritte zwischen den Schritten ($e_{11}$) und (f) umfaßt:

Bilden eines zweiten hochschmelzenden Metallfilms (25) über die gesamte Oberfläche der Vorrichtung und Umwandeln des zweiten hochschmelzenden Metallfilms (25) in einen Silizid-Film (16) durch Wärmebehandlung sowie Abätzen des verbleibenden hochschmelzenden Metalls.

FIG. 1

FIG. 4

FIG. 2

FIG. 2

FIG. 3

FIG.3

FIG. 5

FIG. 6

FIG. 7

A

22    22    25
8         24
          23
          9
          4
2    N+    p+    3
              1

(a)

B

22    16    23
      24    24
8              9
              4
2    N+    p+    3
              1

(b)

C

22    16    11
      22
8              23
              9
              4
2    N+    p+    3
              1

(C)

FIG. 8